# EUROPÄISCHE PATENTSCHRIFT

(11) **EP 3 051 927 B1**
(45) Veröffentlichungstag und Bekanntmachung des Hinweises auf die Patenterteilung: **28.02.2018**
(21) Anmeldenummer: 16152955.7
(22) Anmeldetag: 27.01.2016
(51) Int. Cl.: H05H 1/24, H05H 1/48, H01J 37/32

(54) **PLASMABEHANDLUNGSGERÄT**
PLASMA TREATMENT DEVICE
APPAREIL DE TRAITEMENT AU PLASMA

(30) Priorität: 29.01.2015 DE 102015101315
(43) Veröffentlichungstag der Anmeldung: 03.08.2016
(73) Patentinhaber: Leibniz-Institut für Plasmaforschung und Technologie e.V., 17489 Greifswald (DE)
(72) Erfinder: Weltmann, Klaus-Dieter, 18609 Ostseebad Binz (DE); Gerling, Torsten, 17489 Greifswald (DE); Lembke, Norbert, 17489 Greifswald (DE)
(74) Vertreter: Gerstein, Hans Joachim

(56) Entgegenhaltungen:
- CN-A- 101 778 525
- CN-U- 204 122 251
- DE-A1-102013 000 440
- JP-A- 2008 021 543
- US-A1- 2014 110 375

## Beschreibung

Die Erfindung betrifft ein Plasmabehandlungsgerät gemäß Anspruch 1. Die vorliegende Offenbarung betrifft weiterhin ein Verfahren zur Plasmabehandlung einer Oberfläche mit einem solchen Plasmabehandlungsgerät.
Plasma ist neben fest, flüssig und gasförmig der vierte Aggregatzustand von Materien. Es lässt sich in Form eines Niedertemperaturplasmas als mindestens teilweise ionisiertes Gas für zahlreiche Anwendungen zur Behandlung von Oberflächen nutzen. So ist eine Oberflächenaktivierung denkbar, aber auch eine Oberflächenreinigung aufgrund der desinfizierenden/sterilisierenden Wirkung von Niedertemperaturplasma.
DE 10 2006 019 664 A1 beschreibt ein Kaltplasma-Handgerät zur Plasmabehandlung von Oberflächen. In einem Handgriff bzw. Handgehäuse ist eine Hochspannungseinheit mit einem Anpassungsnetzwerk zur Erzeugung der zur Plasmaerzeugung benötigten Hochspannung eingebaut. Ein Prozessgas wird durch die Hochspannungseinheit geleitet. Der nach Durchleiten durch den Hochspannungsgenerator erzeugte Plasmastrahl wird durch den Gasstrom nach außen getrieben und tritt relativ stark fokussiert aus. Um den Plasmastrom aufzuweiten, kann die Plasmadüse verbreitert und mit einem Schlitz versehen werden.

DE 10 2009 028 190 A1 offenbart ein Plasma-Handgerät mit einem integrierten Hochfrequenzgenerator und einem Gaseinlass zur Zufuhr von Prozessgas. Wiederum tritt ein Plasmastrahl getrieben durch das Prozessgas aus einer Düse am stirnseitigen Ende des Plasma-Handgerätes aus. Durch die Integration der Plasmadüse, der Hochspannungsquelle und eines Hochfrequenzgenerators in das handliche Plasmawerkzeug wird die elektromagnetische Störabstrahlung reduziert. Für unterschiedliche Plasmastrahlen können verschiedene Arten von Elektroden, wie nadelförmige Elektroden, messerförmige Elektroden oder mehrere nebeneinander angeordnete nadelförmige Elektroden vorgesehen sein.

In DE 10 2009 047 220 A1 ist eine Vorrichtung und ein Verfahren zur Erzeugung eines gepulsten, kalten Atmosphärendruckplasmas zur punktgenauen antimikrobiellen Plasmabehandlung (Entkeimung, Desinfektion, Sterilisation, Dekontamination) kleinster Flächen und Kavitäten beschrieben. Ein Prozessgas wird über einen Gaseinlass in ein Handgerät eingeleitet und zur Ionisierung durch eine Hochspannungselektrode geführt. Als Gegenelektrode dient das zu behandelnde, elektrisch leitfähige Objekt. Zur Vergrößerung der beaufschlagten Ebene kann zur Hochskalierung eine Parallelschaltung mehrerer Elektroden vorgesehen sein.

CN 101778525 A beschreibt eine pneumatisch rotierbare Luftplasmajet-Quelle, bei der ein Plasmastrahl aus einer rotierbaren, schräg ausgerichteten Düse ausströmt.

DE 10 2013 000 440 A1 offenbart ein Plasma-Behandlungsgerät zur Behandlung einer Oberfläche mit einem dielektrisch behinderten Plasmafeld, das zwischen einer mit Hochspannung versorgten Elektrode und der Oberfläche erzeugt wird. Die Elektrode bildet mit einem die Elektrode umgebenden Dielektrikum eine drehbar in einem Griffgehäuse gelagerte Rolle. Damit wird ein dielektrisch behindertes Plasmafeld zwischen der mit Hochspannung versorgten Elektrode und der Oberfläche erzeugt.

CN 204122251 U zeigt einen Luftionisierer mit einer rotierbaren Elektrode zur Erzeugung von Koronaentladung zwischen der rotierenden Elektrode und einer Gegenelektrode. Damit rotiert die Koronaentladung, was zu einem größeren Plasmavolumen führt, das gleichmäßig durch den Luftstrom zwischen den beiden Elektroden verteilt wird. Dies führt zu einer Reinigung der Umgebungsluft.

US 2014/0110375 A1 zeigt ein Plasmabehandlungsgerät mit einer Plasmaerzeugungseinheit, die Stabelektroden und ein diese umgebendes leitendes Gehäuse als Gegenelektrode aufweist. In dem Gehäuse sind Düsenkanäle vorhanden, um einen zwischen den Stabelektroden und der Gegenelektrode erzeugten Plasmagasstrom ausströmen zu lassen. Die Plasmaerzeugungseinheit ist rotierbar angeordnet, um bspw. den Plasmagasstrom auf die Innenwand eines Zylinders aufzubringen.

JP 2008 021543 A offenbart ein Gerät zur Behandlung einer Oberfläche mit Koronaentladung. Hierzu sind hohle Stabelektroden an einem rotierbaren Elektrodenhalter angeordnet. Die mit Gas durchströmten Stabelektroden werden mit Hochspannung beaufschlagt, um auf diese Weise eine Koronaentladung zwischen den Stabelektroden und der zu behandelnden Oberfläche zu bewirken. Durch die Rotation der Stabelektroden wird die Koronaentladung auf der Oberfläche verwirbelt und verteilt.

Ausgehend hiervon ist es Aufgabe der vorliegenden Erfindung, ein verbessertes Plasmabehandlungsgerät und ein verbessertes Verfahren zur Plasmabehandlung einer Oberfläche mit einem solchen Plasmabehandlungsgerät zu schaffen, bei dem bei möglichst einfachen Aufbau und Handhabung der von dem Plasmastrahl beaufschlagte Oberflächenbereich vergrößert und damit die Behandlungszeit reduziert wird.

Die Aufgabe wird mit dem Plasmabehandlungsgerät mit den Merkmalen des Anspruchs 1 gelöst. Vorteilhafte Ausführungsformen sind in den Unteransprüchen beschrieben.
Es wird vorgeschlagen, dass die Elektrodenanordnung des Plasmabehandlungsgerätes mindestens eine beweglich gelagerte Elektrode hat und das Plasma mittels Bewegung der mindestens einen Elektrode ortsveränderlich erzeugbar ist.
Durch die ständige, automatische Bewegung der mindestens einen Elektrode wird der Zündbereich zwischen dem effektiv wirksamen Abschnitt der bewegten Elektrode und einer Gegenelektrode, die auch ein elektrisch leitfähiges, zu behandelndes Objekt sein kann, ständig variiert. Damit wird der mit dem Plasmagasstrom beaufschlagte und damit behandelte Oberflächenbereich bei gleichbleibender Ausrichtung des Plasmabehandlungsgerätes auf die zu behandelnde Oberfläche der im Vergleich zur unbewegten Elektrode bei stillstehendem Plasmabehandlungsgerät vergrößert.
Während im Stand der Technik die von dem Plasmagasstrom beaufschlagte Fläche durch Aufweitung des Düsenkopfes z. B. mithilfe eines Schlitzes oder durch Parallelschaltung mit dazugehörigen Düsen oder durch Bewegung des Düsenkopfes vergrößert wird, schlägt die vorliegende Erfindung eine angetriebene Bewegung der Elektrodenanordnung vor. Somit wird der vom erzeugten Plasmastrom beaufschlagte Oberflächenbereich bei feststehender Ausrichtung des Plasmabehandlungsgerätes auf die zu behandelnde Oberfläche bereits im Moment der Zündfunkenerzeugung vergrößert und nicht durch eine spätere Ausrichtung des Plasmagasstroms. Dies hat den Vorteil, dass ein in einem durchgeleiteten Gasstrom erzeugtes Plasma auf einfache Weise während des Durchströmens großflächig auf den Gasstrom wirkt.

Dies schließt allerdings nicht aus, dass zusätzlich noch der ausströmende Plasmagasstrom weiter zum Beispiel durch einen rotierenden Düsenkopf verteilt wird.
Die Elektrode kann linear, rotatorisch, mit mehreren überlagerten Bewegungsrichtungen oder auf sonstige geeignete Weise bewegt werden.
Die beweglich gelagerte Elektrode ist vorzugsweise die mit Hochspannungspotenzial beaufschlagte Elektrode, die benachbart zu einer mit Massepotential verbundenen Gegenelektrode angeordnet ist. In der vorliegende Erfindung ist diese Gegenelektrode ein Teil der Elektrodenanordnung im Plasmabehandlungsgerät. Denkbar ist aber auch, dass die Gegenelektrode durch die zu behandelnde Oberfläche gebildet wird. So kann die leitfähige Gegenelektrode z. B. durch ein Fluid, wie z. B. Wasser gebildet sein.
In einer bevorzugten, sehr handlichen Ausführungsform hat die Elektrodenanordnung vorzugsweise einen rotierbar angeordneten Zylinder. Die mindestens eine Elektrode ist dann z.B. als spiralförmig auf dem Zylinder angeordnete Leiterbahn oder Leiterdraht ausgebildet. Die Leiterbahn kann beispielsweise stoffschlüssig mit der Zylinderoberfläche verbunden sein. Denkbar ist aber auch, dass ein Leiterdraht oder ein elektrisch leitfähiger Materialstreifen um die Oberfläche des Zylinders gewunden ist. Unter einer Anordnung auf dem Zylinder wird aber auch verstanden, dass die Leiterbahnen oder der Leiterdraht mindestens teilweise in den Zylinder eintauchen. So ist denkbar, dass der Zylinder mindestens eine spiralförmig gewundene Nut aufweist, in die eine elektrisch leitfähige Leiterbahn oder solcher Leiterdraht eingelegt wird.
Durch die Rotation des Zylinders, der die spiralförmige Leiterbahn oder Leiterdraht trägt, wird der Zündbereich zwischen jeweils einem Punkt auf der Leiterbahn bzw. dem Leiterdraht und dem nächstliegenden Bereich der Gegenelektrode ständig in seine Position verändert. Dies führt dazu, dass die bei der Beaufschlagung der mindestens einen Elektrode mit Hochspannungspotential entstehenden Zündfunken bei der Rotation des Zylinders ständig wandern und ihre Ortsposition verändern. Bei einem relativ zur behandelnden Oberfläche feststehendem Plasmabehandlungsgerät wird, wenn zum Beispiel die zu behandelnde Oberfläche die Gegenelektrode bildet, hierdurch ein im Vergleich zur stillstehenden Elektrode größerer Oberflächenbereich entlang der Zylinderlänge in Erstreckungsrichtung des Zylinders durch das erzeugte Plasma behandelt.
Denkbar ist aber auch, dass die Elektrodenanordnung eine den Zylinder mit einem Abstand umgebene Gegenelektrode hat. Dabei eine Gaszuführung kommunizierend mit dem Zwischenraum zwischen dem Zylinder und der dem Zylinder umgebenen Gegenelektrode verbunden, um einen Gasstrom in den Zwischenraum zu leiten. Durch die Rotation des den mindestens eine Leiterbahn oder den Leiterdraht spiralförmig tragenden Zylinders wird durch die ständig ortsverändert erzeugten Zündfunken ein Plasma nahezu in dem gesamten Raum zwischen Zylinderoberfläche und benachbarter Innenwand der Gegenelektrode erzeugt. Dieser Raum wird durch den Gasstrom durchströmt, der durch die Zündfunken ionisiert wird. Somit wird ein Plasmagasstrom großflächig erzeugt, der aus dem durchströmten Raum zwischen Zylinder und Gegenelektrode ausströmt. Dieser Plasmagasstrom muss nicht wie bei der herkömmlichen Plasmagaserzeugung stark fokussiert sein und kann auf einen größeren Oberflächenbereich unmittelbar aufgebracht werden, ohne dass eine Auffächerung eines fokussierten Gasstroms notwendig ist. Dieses ist dadurch bedingt, dass das Plasma ortsveränderlich im Gasstrom erzeugt wird und damit ein größeres Volumen des Plasmagasstroms ionisiert werden kann.
Die Gegenelektrode ist dabei vorzugsweise rohrförmig und umgibt den mindestens eine Elektrode tragenden Zylinder konzentrisch. Denkbar ist aber auch, dass die Gegenelektrode nur einen Teilumfang des Zylinders umgibt. In der vorliegenden Erfindung ist mindestens eine Stabelektrode an einem rotierbaren um eine Rotationsachse angeordneten Trägerelement angeordnet. Die Stabelektrode erstreckt sich dabei versetzt zur Rotationsachse in einer Richtung parallel zur Rotationsachse oder in einem spitzen Winkel zur Rotationsachse. Während beim ersten Beispiel die mindestens eine Elektrode am Umfang eines rotierenden Zylinders wirkt, ist bei dieser Ausführungsform die Stabelektrode an der Stirnfläche des rotierbaren Trägerelementes angeordnet. Die Stabelektrode kann somit an dem Kopf eines Handgehäuses des Plasmabehandlungsgerätes wirken und dort einen Zündfunken zur Plasmaerzeugung mithilfe einer benachbart zum freien Ende der Stabelektrode angeordneten Gegenelektrode bewirken, wenn die Stabelektrode mit Hochspannungspotential beaufschlagt ist. Durch die Rotation des Trägerelements um eine Rotationsachse beschreibt die Spitze der Stabelektrode eine um die Rotationsachse laufende Umlaufbahn. Diese Umlaufbahn kann konzentrisch zur Rotationsachse sein, muss es aber nicht zwingend. Denkbar ist auch eine ellipsenförmige Umlaufbahn für den Fall, dass der Stabelektrode eine weitere Bewegung über die Rotation um die Rotationsachse des Trägerelements hinaus überlagert ist. Besonders vorteilhaft ist es, wenn die Spitze der Stabelektrode als wirksamer Abschnitt zur Erzeugung des Plasmazündfunkens genutzt wird. Hierzu ist dann benachbart der Spitze der mindestens einen Stabelektrode eine Gegenelektrode angeordnet. Diese Gegenelektrode kann entweder die zu behandelnde Oberfläche des Objektes sein, welche vorzugsweise auf Massepotential liegt. In der vorliegenden Erfindung ist die Gegenelektrode als Teil der Elektrodenanordnung in das Plasmabehandlungsgerät eingebaut. Besonders vorteilhaft ist es wenn, wie im Fall der vorliegenden Erfindung, die Gegenelektrode als Platte mit einer Mehrzahl von Öffnungen ausgeführt ist, wobei die Mehrzahl von Öffnungen auf mindestens einer Umlaufbahn, die jeweils an die Umlaufbahn der Spitze der mindestens einen Stabelektrode angepasst ist, verteilt angeordnet sind. Bei der Anordnung mehrerer Stabelektroden können Öffnungen auf unterschiedlichen Umlaufbahnen an die jeweiligen Stabelektroden angepasst vorgesehen sein.

Wenn die Stabelektrode nun um die Rotationsachse des Trägerelementes rotiert und die plattenförmige Gegenelektrode in etwa lotrecht zur Rotationsachse benachbart zur Spitze der mindestens einen Stabelektrode angeordnet ist, wird die Spitze der Stabelektrode bei der Rotationsbewegung regelmäßig auf eine der Öffnungen in der Platte ausgerichtet sein. Dann wird bei ständiger Beaufschlagung der Stabelektrode mit einer Hochspannung ein Zündfunken erzeugt, wenn die Spitze der Stabelektrode die Öffnung überstreicht. Dieser Zündfunke erlischt dann wieder, wenn die Stabelektrode näher zu dem elektrisch leitfähigen Material der Gegenelektrodenplatte positioniert ist. Durch diese Selbstzündung bei rotierender Stabelektrode ist nicht nur eine Zündsteuerungselektronik entbehrlich. Es wird auch erreicht, dass die Temperatur des erzeugten Plasmagasstroms reduziert ist.

Für diese Selbstzündung ohne zusätzliche Steuerungselektronik ist es vorteilhaft, wenn die Gegenelektrode aus einem dielektrischen Material besteht. Die mindestens eine Stabelektrode kann dann mit einer DC-Hochspannungsquelle (Gleichspannung) oder vorzugsweise mit einer hochfrequenten Hochspannungsquelle im MHz-Bereich versorgt werden. Durch die MHz-Hochspannungsversorgung wird die Selbstzündung bei einer dielektrischen Gegenelektrode verbessert und sichergestellt, dass das erzeugte Plasma eine hinreichend geringe Temperatur hat, um bei der Behandlung einer Oberfläche diese nicht durch Temperatureinfluss zu beeinflussen.

Das Plasmabehandlungsgerät hat vorzugsweise eine elektrische, pneumatische oder hydraulische Antriebseinheit, die zur Bewegung mit der mindestens einen Elektrode direkt oder mit dem die Elektrode tragenden Zylinder oder Trägerelement gekoppelt ist. Die mindestens eine Elektrode wird damit zum Beispiel mithilfe eines Elektromotors in eine Rotationsbewegung versetzt, so dass das Plasma mithilfe der Antriebseinheit ortsveränderlich erzeugt wird.

Denkbar ist aber auch, dass die mindestens eine Elektrode oder ein die mindestens eine Elektrode tragender Zylinder oder Trägerelement eine Oberflächenkontur hat, die zum rotatorischen Antrieb der mindestens einen Elektrode durch Leiten eines Gasstroms über die Oberflächenkontur ausgebildet ist. Die Oberflächenkontur kann beispielsweise spiralförmige Vertiefungen oder Erhebungen haben. Als Gasstrom kann der in das Plasmabehandlungsgerät einströmende Gasstrom genutzt werden, in dem durch Ionisierung mittels Zündfunken ein Plasma erzeugt wird und der dann als Plasmagasstrom aus dem Plasmabehandlungsgerät ausströmt. Dieser Gasstrom wird dann an der Oberflächenkontur entlang geleitet und bewirkt hierdurch eine Rotationsbewegung. So kann beispielsweise ein den mindestens eine Elektrode tragender Zylinder oder ein mindestens eine Elektrode tragendes Trägerelement durch Konturierung als Antriebselement ausgestaltet werden, um dieses durch den Gasstrom in einer Rotationsbewegung zu versetzen. Eine gesonderte Antriebseinheit ist dann nicht mehr erforderlich. Damit kann das Plasmabehandlungsgerät sehr einfach und kompakt aufgebaut werden.

Das Plasmabehandlungsgerät hat vorzugsweise einen Handgriff, in dem die Elektrodenanordnung integriert ist. So kann das Plasmabehandlungsgerät beispielsweise ein rohrförmiges Gehäuse haben, das als Gehäuse für die Elektrodenanordnung dient und den Handgriff bildet.

Die Erfindung wird nachfolgend anhand von Ausführungsbeispielen mit den beigefügten Zeichnungen näher erläutert. Es zeigen:
- Figur 1: - Skizze einer Ausführungsform eines Plasmabehandlungsgerätes mit rotierbarer Stabelektrode nach der vorliegenden Erfindung;
- Figur 2a: - Skizze eines ersten Beispiels eines Plasmabehandlungsgerätes mit spiralförmiger Elektrode auf einem rotierbaren Zylinder benachbart zu einer planen zu behandelnden Oberfläche als Gegenelektrode in einer ersten Position;
- Figur 2b: - Skizze eines zweiten Beispiels eines Plasmabehandlungsgerätes mit spiralförmiger Elektrode auf einem rotierbaren Zylinder benachbart zu einer planen zu behandelnden Oberfläche als Gegenelektrode in einer zweiten Position;
- Figur 3: - Skizze eines weiteren Beispiels eines Plasmabehandlungsgerätes mit spiralförmiger Elektrode auf einem rotierbaren Zylinder benachbart zu einer planen zu behandelnden Oberfläche als Gegenelektrode bei hoher Umdrehungsgeschwindigkeit;
- Figur 4: - Skizze eines weiteren Beispiels eines Plasmabehandlungsgerätes mit einer spiralförmigen Elektrode tragendem rotierbaren Zylinder mit einer umgebenen rohrförmigen Gegenelektrode.

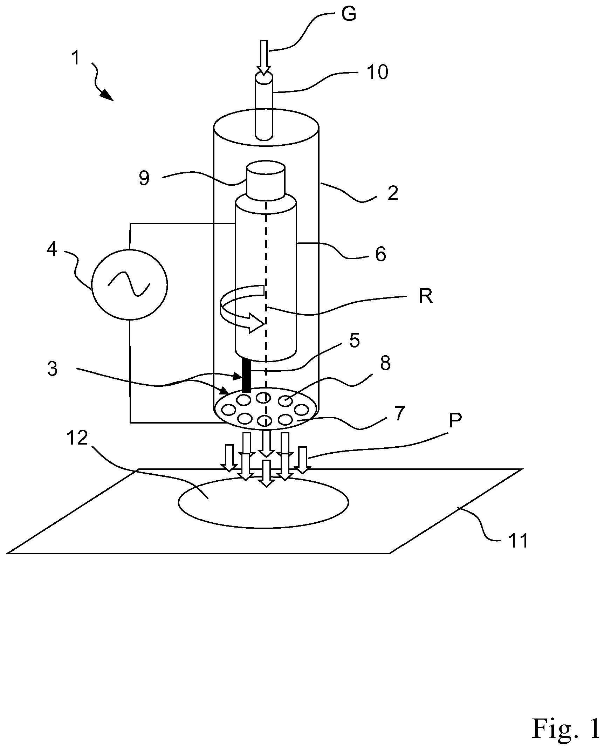

Figur 1 lässt eine Skizze eines Plasmabehandlungsgerätes 1 mit einem Handgehäuse 2 erkennen. Im Innenraum des Handgehäuses 2 ist eine Elektrodenanordnung 3 eingebaut, die mit einer Hochspannung aus einer Hochspannungsquelle 4 versorgt wird. Die Elektrodenanordnung 3 hat eine Stabelektrode 5, die an der Stirnseite eines rotierbar angeordneten Trägerelementes 6 angeordnet ist. Das Trägerelement 6 ist beispielsweise ein in einer Längserstreckungsrichtung erstreckender Zylinder mit einer kreisförmigen Stirnfläche an einem Ende, welches die mindestens eine Stabelektrode 5 trägt. Dargestellt ist eine einzige Stabelektrode. Denkbar ist aber auch, dass zwei, drei oder mehr Stabelektroden an der Stirnseite angeordnet sind. Die mindestens eine Stabelektrode 5 ist mit der Hochspannungsquelle 4 elektrisch leitend verbunden und wird im Betrieb auf Hochspannungspotential gelegt. Benachbart zum freien Ende der mindestens einen Stabelektrode 5 ist eine Gegenelektrode 7 als Teil der Elektrodenanordnung 3 angeordnet. Diese ist ebenfalls mit der Hochspannungsquelle 4 verbunden und vorzugsweise auf Massepotential während des Betriebs gelegt. Erkennbar ist, dass die plattenförmige Gegenelektrode 7 über eine Umlaufbahn verteilt angeordnete Öffnungen 8 hat. Diese Umlaufbahn entspricht der Umlaufbahn der Spitze der Stabelektrode 5, wenn diese sich durch Rotation des Trägerelementes 6 um die Rotationsachse R des Trägerelementes 6 bewegt. In dem dargestellten Ausführungsbeispiel erstreckt sich die mindestens eine Stabelektrode 5 parallel zur Erstreckungsrichtung der Rotationsachse R. Denkbar ist aber auch, dass die Stabelektrode 5 schräg hierzu gestellt ist und im spitzen Winkel vorzugsweise im Bereich von 0 bis 45 Grad zur Rotationsachse steht. Damit kann der Flächenbereich, der von der mindestens einen Stabelektrode 5 überstrichen wird, gegebenenfalls ohne Vergrößerung des Umfangs des Trägerelementes 6 vergrößert werden.

Das Trägerelement 6 ist mit einer Antriebseinheit 9 gekoppelt. Diese Antriebseinheit 9 kann beispielsweise ein Elektromotor sein. Denkbar ist aber auch, dass die Antriebseinheit 9 ein pneumatisch betriebener Motor ist. Hierbei kann vorteilhaft ein in das Plasmabehandlungsgerät 1 eingeleiteter und aus den Öffnungen 8 der Gegenelektrode 7 ausströmender Gasstrom G genutzt werden.

Unabhängig von der Antriebseinheit 9 hat das Plasmabehandlungsgerät 1 in dem dargestellten Ausführungsbeispiel einen Gaseinlass 10 zum Einlassen des Gasstroms G, der dann an dem Trägerelement 6 entlang zu dem Bereich zwischen der Elektrodenanordnung 3 geleitet wird. Wenn die Stabelektrode 5 mit ihrem freien Ende die Öffnung 8 in der Gegenelektrode 7 überstreicht, wird dann jeweils ein Zündfunke erzeugt, der den Gasstrom ionisiert und zu einem Plasmagasstrom führt. Dieser Plasmagasstrom P tritt dann aus den Öffnungen 8 der Gegenelektrode 7 aus und wird auf die zu behandelnde Oberfläche 11 geleitet. Bei konstant gehaltener Ausrichtung des Plasmabehandlungsgerätes 1 auf die zu behandelnde Oberfläche 11 beziehungsweise das Objekt wird ein im Vergleich zu einem fokussierten Plasmastrahl beaufschlagter, behandelter Oberflächenbereich 12 vergrößert. Dies wird durch die aufgefächerte Erzeugung des Plasmagasstroms P erreicht, welche durch die Rotation der Stabelektrode 9 in Pfeilrichtung um die Rotationsachse R durch ortsveränderte Erzeugung der Zündfunken und des Plasmas bewirkt wird.
Für den Gasstrom G eignen sich Edelgase, Luft oder dergleichen.

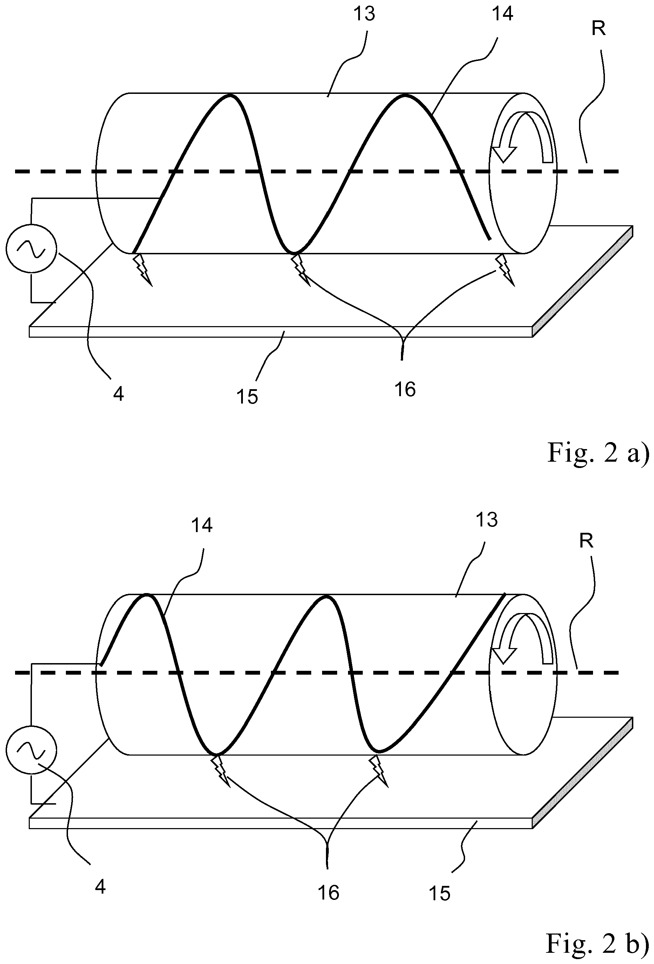

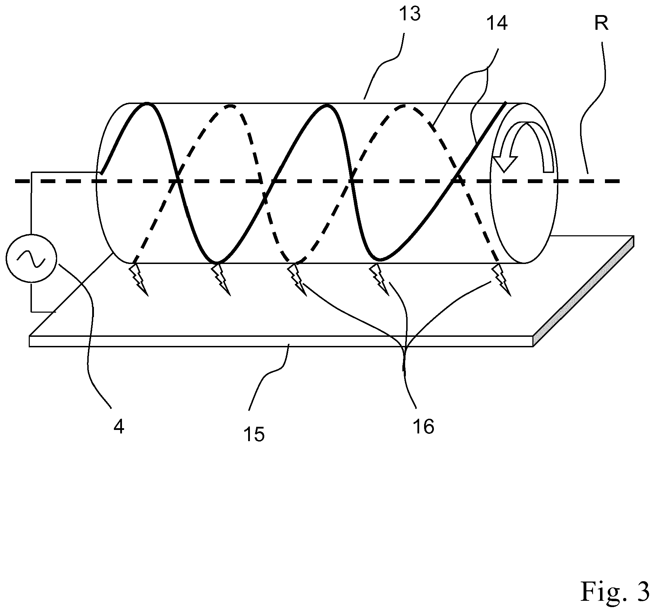

Figur 2a lässt eine Skizze eines ersten Beispiels eines Plasmabehandlungsgerätes 1 in perspektivischer Anordnung erkennen. Das Plasmabehandlungsgerät 1 hat einen rotierbar angeordneten Zylinder 13. Der Zylinder 13 hat an seiner Oberfläche den Zylindermantel umlaufende Elektroden 14 in Form von Leiterbahnen oder Leiterdrähten, die um den Zylinder 13 gewickelt sind. Die mindestens eine Elektrode 14 ist wiederum mit einer Hochspannungsquelle 4 verbunden und im Betrieb auf Hochspannungspotential gelegt. Dabei können mehrere spiralförmig gewundene und nebeneinander angeordnete Elektroden 14 elektrisch parallel geschaltet sein.
Der Zylinder 13 ist benachbart zu einer zum Beispiel plattenförmigen Gegenelektrode 15 angeordnet, die ebenfalls mit der Hochspannungsquelle 4 verbunden und vorzugsweise auf Massepotential gelegt ist. Die Gegenelektrode 15 kann zum Beispiel die zu behandelnde Oberfläche des Objektes sein. Bei der Beaufschlagung der Elektrode 14 mit Hochspannung wird an den Bereichen der spiralförmigen Elektrodenbahn, die der zu behandelnden Oberfläche bzw. der Gegenelektrode 15 am nächsten liegt, jeweils ein Zündfunken und damit ein Plasma erzeugt.
Wenn nun der Zylinder 13 in eine langsame Rotation um die Rotationsachse R herum versetzt wird, dann entstehen ständig neue Zündfunken an anderen Ortspositionen je nach Lage der Bereiche der Elektrode 14, die der Gegenelektrode 14 am Nächsten liegt. Durch die spiralförmige Windung der Elektrode um die Zylinderoberfläche herum wandern somit die Zündfunken auf der Oberfläche der Gegenelektrode 15 entlang. Somit wird bei konstanter Ausrichtung des Zylinders 13 beziehungsweise des Plasmabehandlungsgerätes 1 auf die zu behandelnde Oberfläche beziehungsweise Gegenelektrode 15 durch die Rotation des Zylinders 13 ein Bereich über die Länge in Erstreckungsrichtung des Zylinders 13 mit einen Plasma beaufschlagt.
Wenn nun der Zylinder 13 in eine schnelle Rotationsbewegung versetzt wird, wie in Figur 3 skizziert, werden die Zündfunken 16 über relativ kurze Zeit im nahezu gesamten Raum erzeugt. Es entstehen benachbart zum kurz vorher erzeugten Zündfunken weitere Zündfunken, so dass die Oberfläche des zu behandelnden Objektes 15 nahezu über diese gesamte wirksame Länge des Zylinders 13 mit einem Plasma nahezu gleichzeitig beaufschlagt wird. Nun kann der Zylinder 13 während der Behandlung quer zu der Längserstreckungsrichtung des Zylinders 13 bewegt werden, um auf diese Weise in kurzer Zeit einen relativ großen Oberflächenbereich mit Plasma zu behandeln. Denkbar ist auch eine Nebeneinanderreihung mehrerer Geräte (Array-Schaltung), um einen noch größeren Oberflächenbereich zu behandeln.

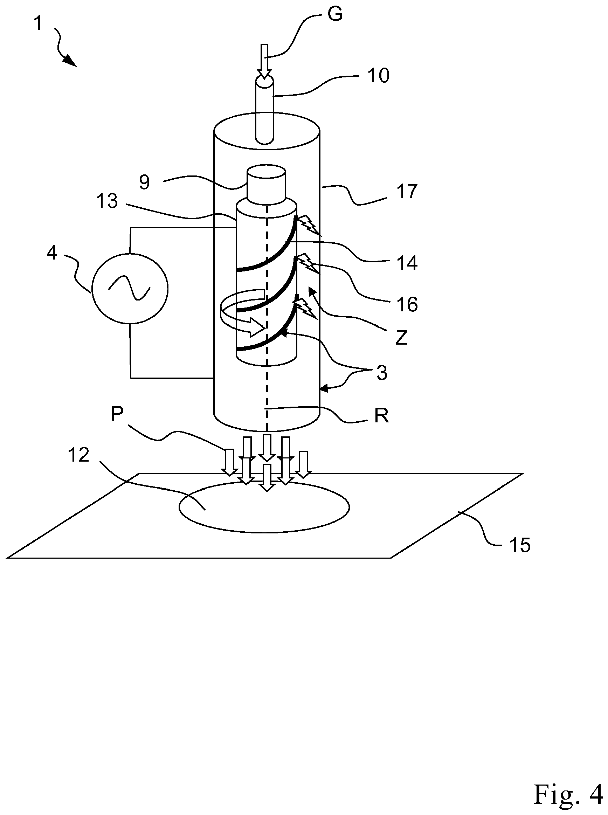

Figur 4 lässt ein weiteres Beispiel eines Plasmabehandlungsgerätes 1 erkennen. Das Plasmabehandlungsgerät 1 hat eine Elektrodenanordnung 3, die aus mindestens einer in Betrieb mit Hochspannung beaufschlagten Elektrode 14 und einer Gegenelektrode 17 gebildet ist. Die mindestens eine Elektrode 14 ist wiederum wie im zweiten Ausführungsbeispiel um die Oberfläche eines rotierbaren Zylinders 13 herumlaufend angeordnet. Unter einem Zylinder wird prinzipiell ein sich in eine Haupterstreckungsrichtung erstreckendes Trägerelement mit einer gekrümmten oder zumindest vieleckigen Oberfläche verstanden.

Die Gegenelektrode 17 ist ein rohrförmiges, den Zylinder 13 konzentrisch umgebenes Gebilde. Die Gegenelektrode 17 ist auch elektrisch leitend mit der Spannungsquelle 4 verbunden und vorzugsweise auf Massepotential gelegt. Durch die Beaufschlagung der Elektrode 14 mit Hochspannung werden dann Zündfunken 16 zwischen Zündbereichen der Elektroden 14 und des nächstliegenden Bereich der Innenwand der Gegenelektrode 17 erzeugt. Diese Zündfunken 13 bewirken ein Plasma in einem Gasstrom G, der durch einen Einlass 10 in den Zwischenraum Z zwischen Zylinder 13 und Innenwand der Gegenelektrode 17 geleitet wird. Der resultierende Plasmagasstrom P wird dann an dem stirnseitigen Ausgang des Plasmabehandlungsgerätes 1 ausgeleitet. Dabei kann die rohrförmige Gegenelektrode 7 auch gleichzeitig das Handgehäuse bilden. Denkbar ist aber auch, dass die rohrförmige Gegenelektrode 17 mit einem Handgehäuse zum Beispiel aus Kunststoffmaterial umgeben ist, an dessen Stirnseite dann der Plasmagasstrom P austritt.
Optional kann an dem stirnseitigen Ausgang des Plasmabehandlungsgerätes 1 noch eine mehr oder weniger fokussierte oder zusätzlich rotierbare Düse zum Lenken des ausströmenden Plasmagasstroms P vorgesehen sein.
Das Plasmabehandlungsgerät 1 wird dann auf die zu behandelnde Oberfläche 15 so ausgerichtet, dass der Plasmagasstrom auf einen mit Plasma behandelten Oberflächenbereich 12 auftritt.
Die Rotation der Elektroden 14 wird vorzugsweise durch eine Antriebseinheit 9 bewirkt. Diese kann als elektrische Antriebseinheit (zum Beispiel Elektromotor) oder als pneumatische oder hydraulische Antriebseinheit ausgeführt sein. So kann die Antriebseinheit 9 zum Beispiel mithilfe des ohnehin zugeführten Gasstroms G betrieben werden.

Bei den beschriebenen Beispielen ist entscheidend, dass die Elektroden 14 sich bewegen, um so den mindestens einen Zündfunken 16 und das hierdurch erzeugte Plasma ortsveränderlich zu erzeugen. Hierdurch wird das effektive Plasmavolumen beziehungswiese die effektive Plasmafläche bei ansonsten konstanter Position des Plasmabehandlungsgerätes 1 vergrößert. Die Effizienz des Plasmabehandlungsgerätes wird somit bereits bei der Plasmaerzeugung durch Bewegung der Elektroden gesteigert und nicht erst durch Ortsveränderung des bereits erzeugten Plasmagasstroms.

## Patentansprüche

1. Plasmabehandlungsgerät (1) mit einer Elektrodenanordnung (3) zur Erzeugung eines Plasmas, insbesondere eines kalten Atmosphärendruckplasmas, wobei mindestens eine Stabelektrode (5) an einem rotierbar um eine Rotationsachse (R) angeordneten Trägerelement (6) angeordnet ist, wobei sich die Stabelektrode (5) versetzt zur Rotationsachse (R) in eine Richtung parallel zur Rotationsachse (R) oder in einem spitzen Winkel zur Rotationsachse (R) erstreckt, und benachbart zur Spitze der mindestens einen Stabelektrode (5) eine Gegenelektrode (7) angeordnet ist, **dadurch gekennzeichnet, dass** die Gegenelektrode (7) als Platte mit einer Mehrzahl von Öffnungen (8) ausgeführt ist, wobei die Mehrzahl von Öffnungen (8) auf mindestens einer Umlaufbahn, die jeweils an die Umlaufbahn der Spitze der mindestens einen Stabelektrode (5) angepasst ist, verteilt angeordnet sind.

2. Plasmabehandlungsgerät (1) nach Anspruch 1, **dadurch gekennzeichnet, dass** die Gegenelektrode (7) dielektrisch oder dielektrisch geschirmt ist.

3. Plasmabehandlungsgerät (1) nach Anspruch 1 oder 2, **dadurch gekennzeichnet, dass** das Plasmabehandlungsgerät (1) eine elektrische, pneumatische oder hydraulische Antriebseinheit (9) hat, die zur Bewegung der mindestens einen Stabelektrode (5) mit der mindestens einen Stabelektrode (5) öder mit dem Trägerelement (6) gekoppelt ist.

4. Plasmabehandlungsgerät (1) nach einem der Ansprüche 1 bis 3, **dadurch gekennzeichnet, dass** die mindestens eine Stabelektrode (5) oder ein die mindestens eine Stabelektrode (5) tragendes Trägerelement (6) eine Oberflächenkontur hat, die zum rotatorischen Antrieb der mindestens einen Stabelektrode (5) durch Leiten eines Gastroms (G) über die Oberflächenkontur ausgebildet ist.

5. Plasmabehandlungsgerät (1) nach einem der vorhergehenden Ansprüche, **dadurch gekennzeichnet, dass** das Plasmabehandlungsgerät (1) einen Handgriff (2) hat, in dem die Elektrodenanordnung (3) integriert ist.

## Claims

1. Plasma treatment device (1), comprising an electrode arrangement (3) for generating a plasma, in particular a cold atmospheric-pressure plasma, wherein at least one rod electrode (5) is disposed on a carrier element (6) as to be rotatable about a rotation axis (R), wherein the rod electrode extends in an offset manner in relation to the rotation axis, in a direction parallel to the rotation axis, or at an acute angle in relation to the rotation axis, and a counter-electrode (7) is disposed adjacent to a tip of the at least one rod electrode (5), **characterized in, that** the counter-electrode (7) is a plate having a plurality of openings (8), wherein the plurality of openings (8) are disposed in a distributed manner on at least one orbit, which is matched, respectively, to the orbit of the tip of the at least one rod electrode (5).

2. Plasma treatment device (1) according to claim 1, **characterized in, that** the counter-electrode (7) is dielectric or dielectrically shielded.

3. Plasma treatment device (1) according to claim 1 or 2, **characterized in, that** the plasma-treatment device (1) comprises an electric, pneumatic of hydraulic drive unit (9), which is coupled to the at least one rod electrode (5) or to the carrier element (6) for the purpose of moving the at least one rod electrode (5).

4. Plasma treatment device (1) according to one of the claims 1 to 3, **characterized in, that** the at least one rod electrode (5) or a carrier element (6) carrying the at least one rod electrode (5) has a surface contour that drives the at least one rod electrode (5) rotationally by routing a gas stream (G) over the surface contour.

5. Plasma treatment device (1) according to one of the preceding claims, **characterized in, that** the plasma treatment device (1) comprising a handle (2) in which the electrode arrangement (3) is integrated.

## Revendications

1. Appareil de traitement au plasma (1) comprenant un arrangement d'électrodes (3) destiné à générer un plasma, notamment un plasma froid à pression atmosphérique, au moins une électrode en baguette (5) étant disposée sur un élément porteur (6) monté rotatif autour d'un axe de rotation (R), l'électrode en baguette (5) s'étendant en étant décalée par rapport à l'axe de rotation (R) dans une direction parallèle à l'axe de rotation (R) ou selon un angle aigu par rapport à l'axe de rotation (R), et une contre-électrode (7) étant disposée voisine de la pointe de l'au moins une électrode en baguette (5), **caractérisé en ce que** la contre-électrode (7) est réalisée sous la forme d'une plaque munie d'une pluralité d'ouvertures (8), la pluralité d'ouvertures (8) étant disposées distribuées sur au moins une trajectoire périphérique, laquelle est respectivement adaptée à la trajectoire périphérique de la pointe de l'au moins une électrode en baguette (5).

2. Appareil de traitement au plasma (1) selon la revendication 1, **caractérisé en ce que** la contre-électrode (7) est diélectrique ou à blindage diélectrique.

3. Appareil de traitement au plasma (1) selon la revendication 1 ou 2, **caractérisé en ce que** l'appareil de traitement au plasma (1) possède une unité d'entraînement (9) électrique, pneumatique ou hydraulique qui, pour le déplacement de l'au moins une électrode en baguette (5), est accouplée avec l'au moins une électrode en baguette (5) ou avec l'élément porteur (6).

4. Appareil de traitement au plasma (1) selon l'une des revendications 1 à 3, **caractérisé en ce que** l'au moins une électrode en baguette (5) ou un élément porteur (6) qui supporte l'au moins une électrode en baguette (5) possède un profil de surface qui est configuré pour l'entraînement en rotation de l'au moins une électrode en baguette (5) en dirigeant un flux de gaz (G) sur le profil de surface.

5. Appareil de traitement au plasma (1) selon l'une des revendications précédentes, **caractérisé en ce que** l'appareil de traitement au plasma (1) possède une poignée (2) dans laquelle est intégré l'arrangement d'électrodes (3).
